# EUROPÄISCHE PATENTSCHRIFT

(11) **EP 3 077 122 B1**
(45) Veröffentlichungstag und Bekanntmachung des Hinweises auf die Patenterteilung: **15.07.2020**
(21) Anmeldenummer: 14818899.8
(22) Anmeldetag: 03.12.2014
(51) Int. Cl.: B05B 5/03, B05B 5/08, B05B 7/24, H05H 1/48, B05B 7/22

(54) **DRUCKLUFT-AUFBEREITUNGSKAMMER**
COMPRESSED AIR TREATMENT CHAMBER
CHAMBRE DE TRAITEMENT D'AIR COMPRIMÉ

(30) Priorität: 04.12.2013 DE 102013018132
(43) Veröffentlichungstag der Anmeldung: 12.10.2016
(73) Patentinhaber: Mayer, Thomas, 88499 Altheim (DE)
(72) Erfinder: Mayer, Thomas, 88499 Altheim (DE)
(74) Vertreter: Otten, Roth, Dobler & Partner mbB Patentanwälte
(86) Internationale Anmeldenummer: PCT/EP2014/076360
(87) Internationale Veröffentlichungsnummer: WO 2015/082522

(56) Entgegenhaltungen:
- WO-A1-2011/161297
- DE-A1- 2 646 798
- DE-A1-102011 011 054
- DE-A1-102012 014 260
- DE-B3-102010 007 479
- US-A- 3 878 469
- US-A- 6 004 375
- US-A1- 2003 061 934

## Beschreibung

Die Erfindung betrifft eine Lackier-Druckluft-Aufbereitungskammer sowie ein Verfahren zur Aufbereitung von Druckluft.

In der Farbspritz- und Lackiertechnik spielt die Verwendung von Druckluft als Trägermedium für die aufzutragende Farbe eine erhebliche Rolle. Druckluft im Sinne der Erfindung umfasst auch Luftgemische oder reine Gase wie beispielsweise Stickstoff, welche zum Einsatz in der Lackiertechnik vorgesehen sind.

Die Erzeugung von Druckluft unter gewünschten Parametern wie Druck, Temperatur und Volumenstrom ist mit erheblichen Kosten im Lackierprozess verbunden. Es existieren beispielsweise Hochrotationszerstäuber und Lackierpistolen, welche Luftvolumina von 100 bis 800 1/min benötigen, um den gewünschten Lackauftrag bereitzustellen. Ungeachtet dessen sind in der Lackiertechnik auch darüber oder darunter liegende Werte durchaus üblich, je nachdem, welches Verfahren eingesetzt wird.

Aus dem Stand der Technik sind Vorrichtungen bekannt, welche über Ionisationskammern eine Aufbereitung der Druckluft bereitstellen, beispielsweise indem über einen mit Hochspannung geladenen Kamm streichende Luft elektrisch neutralisiert wird. Ziel dieser Anordnungen ist es, die zur Verfügung stehende Druckluft optimal zu nutzen und Bereitstellungsvolumen einzusparen.

Die DE 10 2012 014 260 A1 offenbart eine Einrichtung und ein Verfahren zur Steuerung des Brennstoff-Luft-Verhältnisses bei der Verbrennung gemahlener Kohle in einer Kohlekraftwerksbefeuerungsanlage.

Die WO 2011/161297 A1 lehrt eine Vorrichtung und ein Verfahren zur Hochtemperatur-Beschichtung eines Glas-Substrates.

Aus der DE 26 46 798 A1 ist bereits eine Vorrichtung zur elektrischen Aufladung von Teilchen bekannt.

In der US 3 878 469 A wird ein Verfahren und eine Vorrichtung zur Generierung von Ionen bei Ultraschallfrequenzen beschrieben.

Eine Anlage zum Beschichten von Gegenständen kennt man bereits aus der DE 10 2010 007 479 B3.

Ein Verfahren zur Aufbereitung von Druckluft sowie eine Vorrichtung zur Aufbereitung von Druckluft sind aus der DE 10 2011 011 054 A1 bereits bekannt.

Aufgabe der Erfindung ist es, Druckluft für Lackierverfahren derart weiter aufzubereiten, dass im Verarbeitungsprozess Luftvolumen eingespart werden kann, wodurch eine Kostenersparnis erzielt wird. Darüber hinaus ist auch die Lackeinsparung und die Qualitätsverbesserung des Beschichtungsergebnisses durch die Druckluftqualität beeinflussbar.

Diese Aufgabe wird durch eine Lackier-Druckluft-Aufbereitungskammer nach Anspruch 1 sowie ein Lackier-Druckluft-Aufbereitungsverfahren nach Anspruch 15 gelöst. Vorteilhafte Weiterbildungen sowie zweckmäßige Ausgestaltungen sind in den abhängigen Ansprüchen gegeben.

Die erfindungsgemäße Lackier-Druckluft-Aufbereitungskammer zur Verbesserung der Strömungseigenschaften von Druckluft oder Druckgasgemischen im Lackierprozess umfasst:
- ein Gehäuse zur Bildung eines Hohlraums, wobei das Gehäuse einen den Hohlraum begrenzenden Außenmantel umfasst;
- mindestens eine Lufteintrittsöffnung sowie mindestens eine Luftaustrittsöffnung wobei die Lufteintrittsöffnung und die Luftaustrittsöffnung derart angeordnet sind, dass der Hohlraum von der Druckluft oder dem Druckgasgemisch durchströmbar, vorzugsweise in einer Längsrichtung durchströmbar ist;
- mindestens eine innerhalb des Hohlraums angeordnete Elektrode;
- mindestens eine Hochspannungsquelle zur Versorgung der Elektrode mit Hochspannung.

Erfindungsgemäß ist sie dadurch gekennzeichnet, dass
- mindestens eine Isolationslage innerhalb des Hohlraums an einer Innenfläche des Außenmantels angeordnet ist und
- im Inneren des Hohlraums, zwischen der Elektrode und einer Gegenelektrode ein elektromagnetisches Feld vorzugsweise ein inhomogenes elektromagnetisches Feld oder ein teilweise inhomogenes elektromagnetisches Feld mit einer aktiven Zone zur Durchströmung mit aufzubereitender Druckluft erzeugbar ist.

Die Durchströmung des elektromagnetischen Feldes begünstigt die Strömungseigenschaften der Druckluft im nachfolgenden Leitungssystem bis zur Abgabe an einer Lackierpistole sowie die Aufnahme der zu vernebelnden und transportierenden Farbpartikel oder Pulverpartikel. Es wird ein verringerter Luftvolumenverbrauch um mehr als 5% bis 20% oder mehr und/oder eine effektive Materialeinsparung um 5% bis 20% oder mehr beim aufzutragenden Lack verzeichnet, wenn die Druckluft eine erfindungsgemäße Kammer durchlaufen hat. Besonders bevorzugt wird die Luft bei geeigneter Wahl der Parameter des elektromagnetischen Feldes mindestens neutral, bevorzugt mit einer negativen Überschussladung die Kammer verlassen, was insbesondere Staubtransport verhindert. Für besondere Anwendungen ist es auch vorgesehen, dass die Luft die Kammer mit einer positiven Überschussladung verlässt.

Erfindungsgemäß ist auch ein Verfahren zum Betrieb einer erfindungsgemäßen Lackier-Druckluft-Aufbereitungskammer vorgesehen. Der Betrieb dieser Kammer ist dadurch gekennzeichnet, dass zwischen Elektrode und Gegenelektrode ein Hochspannungsfeld, insbesondere ein Hochspannungs-Wechselfeld angelegt ist, wobei eine Hochspannung zwischen 800V und 100kV, insbesondere zwischen 2kV und 20kV, vorzugsweise zwischen 4kV und 16kV und besonders bevorzugt 5kV und 8kV angelegt ist. Die Wahl der anzulegenden Hochspannung hängt von einer Mehrzahl von Parametern ab. Wesentlich ist dabei die Betrachtung der Durchschlagsspannung in der Luft, welche nicht überschritten werden darf, um einen Lichtbogen zwischen den Elektroden zu vermeiden. Insofern hängen die Spannungen wesentlich von den geometrischen Abständen zwischen den Elektroden ab und können die angegebenen Werte bei stark vergrößerten Kammern auch überschreiten.

Relevant für die Erfindung ist, dass die Druckluft ein möglichst intensives Hochspannungsfeld durchläuft. Vorteilhaft kann dabei sein, dass durch das Spannungsfeld zumindest im Grenzbereich ein nichtthermisches Plasma erzeugt wird, welches auf die Strömungseigenschaften der Druckluft Einfluss nimmt.

Unter einem Lackierprozess wird im Sinne der Erfindung insbesondere auch ein Prozess verstanden, bei welchem mit Hilfe von Druckluft auch andere Stoffe als Farben und Lacke, nämlich insbesondere Schmiermittel und/oder insbesondere Trennmittel aufgebracht werden. Schmiermittel sind hierbei insbesondere als Öle und/oder insbesondere als Aerosole und/oder insbesondere als Ölaerosole ausgebildet. Eine Aufbringung von Schmiermitteln erfolgt hierbei insbesondere als Minimalmengenschmierung oder insbesondere in anderen geeigneten Anwendungen.

Vorteilhafte Weiterbildungen sowie zweckmäßige Ausgestaltungen sind in den abhängigen Ansprüchen angegeben. Hierbei ist es auch vorgesehen, die Elektrode und die Gegenelektrode so auszubilden, dass das elektromagnetische Feld als homogenes Feld oder im Wesentlichen homogenes Feld ausgebildet wird. Die Erfindung selbst sowie die beschriebenen Weiterbildungen sollen im Folgenden am Beispiel der Figurenbeschreibung näher erläutert werden. Gleiche Bestandteile sind dabei mit gleichen Bezugszeichen versehen.

Es zeigen
- Fig. 1: Einen Schnitt durch eine Lackier-Druckluft-Aufbereitungskammer mit Isolationszylinder und Flächenelektrode entlang der Linie B-B;
- Fig. 2: Einen Schnitt durch eine Lackier-Druckluft-Aufbereitungskammer mit Isolationszylinder und Flächenelektrode entlang der Linie A-A;
- Fig. 3: Einen Schnitt entsprechend Figur 2 mit angedeuteter aktiven Zone
- Fig. 4: Einen Schnitt durch eine Lackier-Druckluft-Aufbereitungskammer mit Isolationsschicht und Flächenelektrode entlang der Linie D-D;
- Fig. 5: Einen Schnitt durch eine Lackier-Druckluft-Aufbereitungskammer mit Isolationsschicht und Flächenelektrode entlang der Linie C-C;
- Fig. 6: Einen Schnitt durch eine Lackier-Druckluft-Aufbereitungskammer mit Isolationsschicht ohne Flächenelektrode entlang der Linie F-F;
- Fig. 7: Einen Schnitt durch eine Lackier-Druckluft-Aufbereitungskammer mit Isolationsschicht ohne Flächenelektrode entlang der Linie E-E;
- Fig. 8: Einen Schnitt durch eine Lackier-Druckluft-Aufbereitungskammer mit Isolationsschicht und Flächenelektrode entlang der Linie H-H;
- Fig. 9: Einen Schnitt durch eine Lackier-Druckluft-Aufbereitungskammer mit Isolationsschicht und Flächenelektrode entlang der Linie G-G;
- Fig. 10: Einen Schnitt durch eine Lackier-Druckluft-Aufbereitungskammer mit Isolationsschicht und Flächenelektrode entlang der Linie J-J;
- Fig. 11: Einen Schnitt durch eine Lackier-Druckluft-Aufbereitungskammer mit Isolationsschicht und Flächenelektrode entlang der Linie I-I;
- Fig. 12a: eine geschnittene Seitenansicht einer Lackier-Druckluft-Aufbereitungskammer mit zentraler Gegenelektrode und konzentrisch angeordneten Elektrodenkämmen;
- Figur 12b: einen Querschnitt durch die Figur 12a entsprechend der Schnittlinie XIIa-XIIa;
- Fig. 13a: eine geschnittene Seitenansicht einer Lackier-Druckluft-Aufbereitungskammer mit zylindermantelförmiger Gegenelektrode und zentrisch angeordneten Elektrodenkämmen und
- Figur 13b: einen Querschnitt durch die Figur 13a entsprechend der Schnittlinie XIIIa-XIIIa.

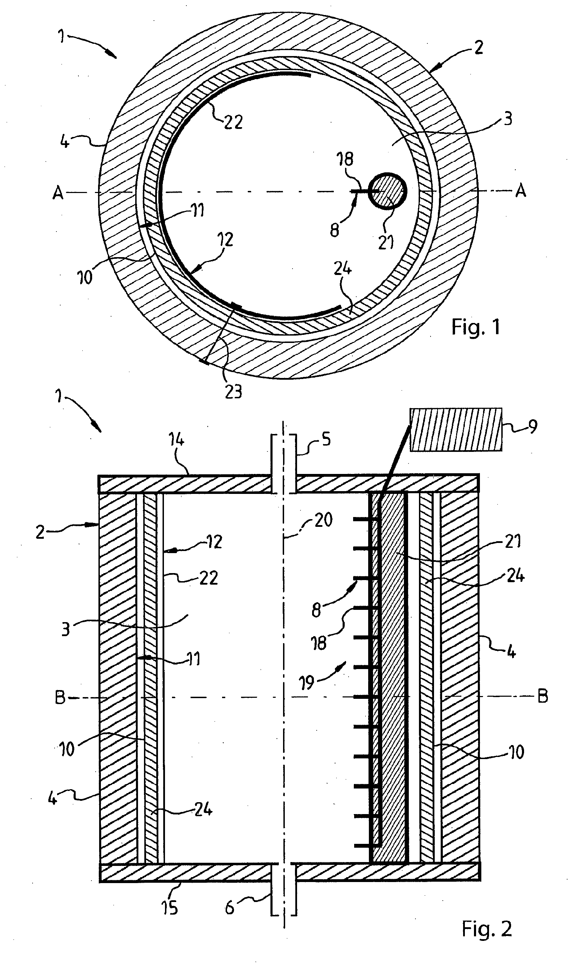

Im Einzelnen zeigen Figur 1 und 2 eine Lackier-Druckluft-Aufbereitungskammer 1. Die Kammer umfasst ein Gehäuse 2 zur Bildung eines Hohlraums 3. Das Gehäuse 2 umfasst weiterhin einen den Hohlraum 3 begrenzenden Außenmantel 4. Das Gehäuse ist vorliegend zylindrisch ausgebildet, kann aber auch andere geometrische Formen, beispielsweise rechteckige Außenkonturen sowie Innenabmessungen aufweisen. Die rotationssymmetrische Fassung ist allerdings für Strömungseigenschaften von Vorteil.

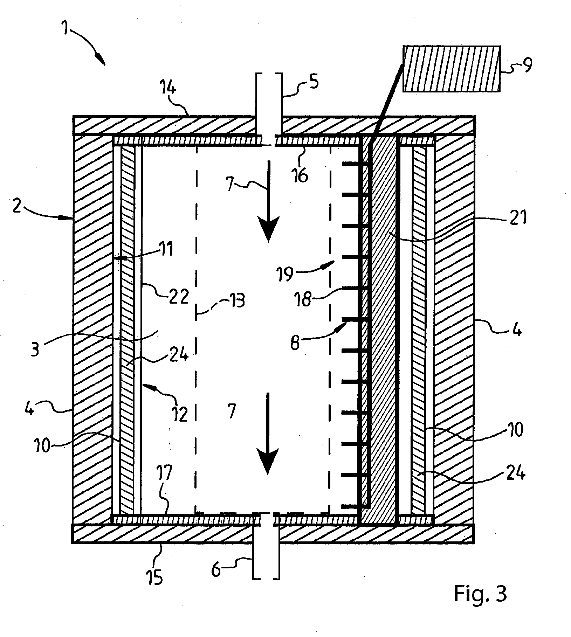

Weiterhin umfasst das Gehäuse 2 eine Lufteintrittsöffnung 5 sowie eine Luftaustrittsöffnung 6 wobei die Lufteintrittsöffnung 5 und die Luftaustrittsöffnung 6 derart angeordnet sind, dass der Hohlraum 3 von der Druckluft oder dem Druckgasgemisch Entlang der Strömungsrichtung 7 durchströmbar ist (siehe Figur 3). Gemäß einer nicht dargestellten Ausführungsvariante ist es auch vorgesehen, dass das Gehäuse mindestens eine und insbesondere mehrere Lufteintrittsöffnungen und/oder mindestens eine und insbesondere mehrere Luftaustrittsöffnungen umfasst.

In dem Hohlraum 3 ist eine Elektrode 8, 19 angeordnet. Die Elektrode 8 ist vorliegend in Form einer Kammelektrode 19 ausgebildet und weist mehrere, kammartig nacheinander angeordnete Elektrodenspitzen 18 auf. Die Elektrodenspitzen 18 sind in einen Elektrodenmantel 21 eingebettet, welcher gegenüber dem Außenmantel 4 oder einer Erdung keine elektrisch leitfähige Verbindung aufweist.

Es ist insbesondere bei größeren Kammern vorteilhaft, mehrere Elektroden auch nebeneinander anzuordnen, um eine ausreichende Feldabdeckung zur Behandlung der Druckluft bereit zu stellen.

Die fehlende elektrische Verbindung des Elektrodenmantels 21 zum Außenmantel 4 des Gehäuses 2 ist eine unübliche Anordnung und stellt in erfindungsgemäßer Weise das benötigte elektromagnetische Feld zwischen Kammelektrode 19 und Gegenelektrode 12 bereit.

Die erfindungsgemäße Lackier-Druckluft-Aufbereitungskammer 1 umfasst mindestens eine Hochspannungsquelle 9 zur Versorgung der Elektrode mit verfahrensgemäßer Hochspannung.

Innerhalb des Hohlraums 3 an einer Innenfläche 11 des Außenmantels 4 ist eine Gegenelektrode 12 in Form einer Flächenelektrode 22 derart angeordnet, dass im Inneren des Hohlraums 3, zwischen der Elektrode 19 und einer Gegenelektrode 12, 22 ein inhomogenes elektromagnetisches Feld mit einer aktiven Zone 13 zur Durchströmung mit aufzubereitender Druckluft erzeugt wird.

Die Isolationslage ist vorliegend als Hohlzylinder 24 ausgebildet und bedeckt mindestens 75% der Innenfläche, vorliegend die gesamte Innenfläche 11 des Außenmantels 4.

Es ist überdies vorgesehen, dass das Gehäuse 2 zwei Abschlussdeckel 14, 15 umfasst wobei mindestens einer, vorzugsweise beide Abschlussdeckel 14, 15, wie in Figur 3 dargestellt, auf einer dem Hohlraum 3 zugewandten Seite eine Isolationslage 16, 17 aufweisen oder eine Isolationslage zwischen Hohlraum und Abschlussdeckel als separates Bauteil angeordnet ist.

Bei der Herstellung des Gehäuses als Drehteil kann zumindest ein Abschlussdeckel einstückig mit dem Außenmantel ausgebildet sein.

Alle gezeigten Ausführungsformen der Figuren 1 bis 7 zeigen, dass die Elektrode 8 asymmetrisch zu einer Mittelachse 20 des Hohlraums 3 positioniert ist. Die Positionierung ist nahezu frei, den Strömungsparametern angepasst wählbar. Es hat sich als vorteilhaft herausgestellt, insbesondere im Verhältnis ca. 1/3 zu 2/3 zwischen dem Außenmantel 3 und der Mittelachse 20 die Elektrode 8 anzuordnen. Bei größeren Kammern sind auch mehrere Elektroden innerhalb eines Hohlraums denkbar, welche sodann entsprechend zueinander zu beabstanden sind. Es hat sich auch als vorteilhaft herausgestellt, dass die Elektrode bzw. die Elektroden zu der Gegenelektrode einen Abstand von 1cm bis 20cm und insbesondere 1cm bis 15cm und vorzugsweise 2cm bis 12cm aufweisen.

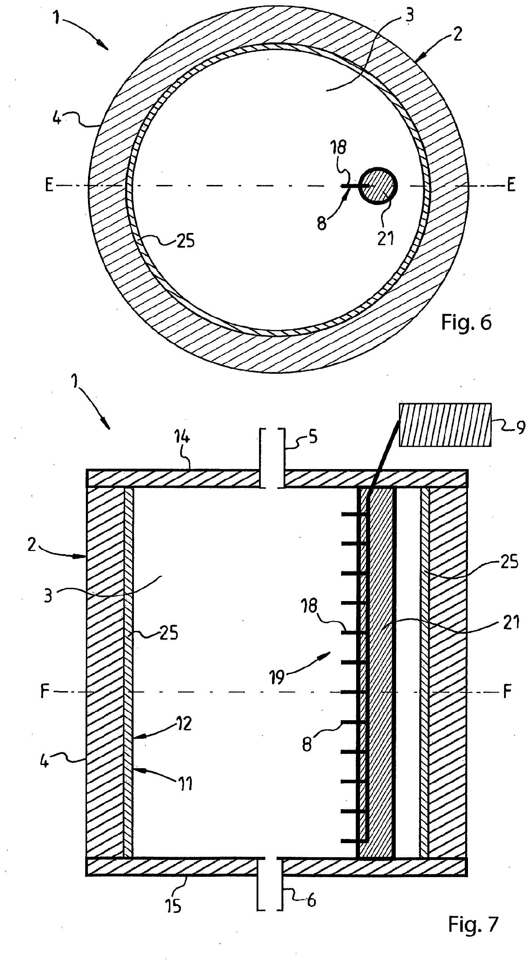

Eine besondere Ausführungsform der Lackier-Druckluft-Aufbereitungskammer 1 ist in Figur 6 und 7 dargestellt. Dabei ist die Gegenelektrode 12 durch die Innenfläche 11 des Außenmantels 4 unter Zwischenschaltung der Isolationslage 25 als Dielektrikum gebildet ist. Diese besonders einfach auszuführende Fassung der Aufbereitungskammer genügt bereits einer Vielzahl von Anwendungen.

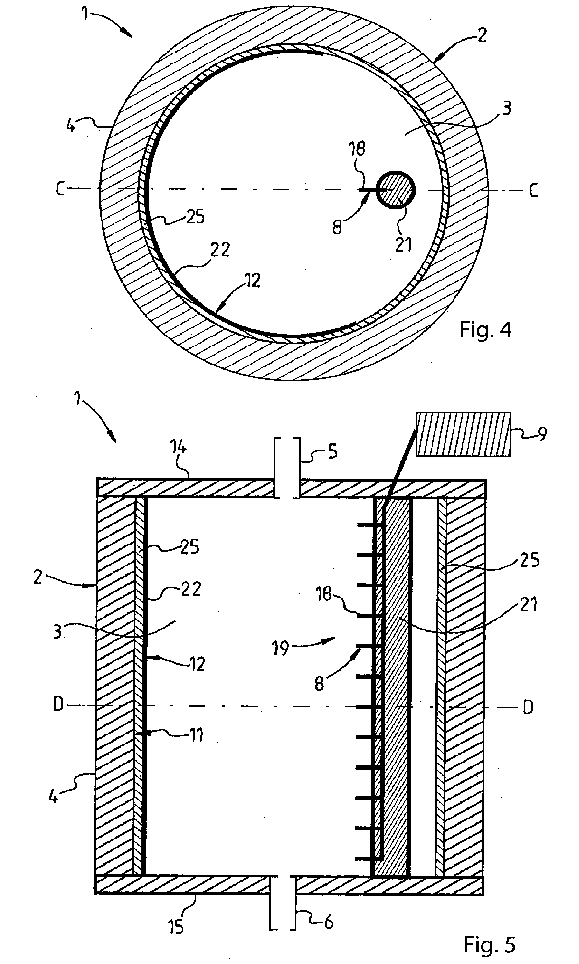

Eine Erweiterung der Ausführung nach Figur 6 und 7 ist in einer Lackier-Druckluft-Aufbereitungskammer 1 nach Figur 4 und 5 dargestellt. Dabei wird die Gegenelektrode 12 durch eine Flächenelektrode 22 unter Zwischenschaltung der Schicht-Isolationslage 25 als Dielektrikum zwischen Flächenelektrode 22 und Innenfläche 11 des Außenmantels 4 gebildet. Die Verwendung einer Flächenelektrode 22 aus elektrisch leitfähigem Material verbessert die Ausbildung des elektromagnetischen Feldes zur erfindungsgemäßen Wirkung auf die Druckluft.
Zur weiteren Verbesserung des elektromagnetischen Feldes ist exemplarisch in Figur 1 dargestellt, dass die Gegenelektrode 12 mit dem Außenmantel 4 verbunden, vorzugsweise über eine elektrisch leitende Verbindung 23 in Form von Verschraubungen oder dergleichen elektrisch leitfähig verbunden ist. Selbstverständlich kann eine entsprechende Verbindung bei allen Varianten nach den Figuren 1 bis 7 vorgesehen werden.

Obwohl in den Figuren nicht näher dargestellt ist es dennoch erfindungsgemäß, die Flächenelektrode 22 als metallisches Gitter auszubilden. Ein Gitter bietet dem elektromagnetischen Feld ebenfalls eine gute Gegenelektrode, wobei insbesondere der Feldaufbau durch Gittereffekte verstärkt wird.

Auch die Ausbildung der Flächenelektrode als metallische Vollfläche ist jedoch denkbar.

In den Varianten nach Figur 1 bis 3 ist die Isolationslage 10 als in den Hohlraum 3 eingeschobener Hohlkörper, insbesondere als Rohrabschnitt oder Hohlzylinder 24 ausgebildet. Der einfache Einschub eines Hohlzylinders 24 stellt eine kostengünstige und wartungsfreundliche Bereitstellung einer Isolationslage 10 dar.

Alternativ kann die Isolationslage 10, wie in den Figuren 4 bis 7 dargestellt, auch als auf der Innenfläche 11 des Außenmantels 4 aufgebrachte Schicht, insbesondere als chemisch aufgebrachte Schicht oder Lackschicht oder Kunststoff-Schmelzschicht oder dergleichen ausgebildet sein. Hierbei können die Isolationseigenschaften eingestellt und entsprechend der Schichtdicke feinjustiert werden. Hinzu kommt die Möglichkeit der einstückigen Produktfertigung, ohne dass Zylinder oder dergleichen manuell eingeschoben werden müssen.

In der erfindungsgemäßen Lackier-Druckluft-Aufbereitungskammer 1 umfasst die aktive Zone mindestens 1/3 des Hohlraumdurchmessers, vorzugsweise zwischen 1/3 bis 2/3 des Hohlraumdurchmessers, insbesondere 1/2 des Hohlraumdurchmessers, um einen ausreichenden Volumenstrom an Druckluft aufzubereiten.

Die Mittelachse des Hohlraums entspricht der Strömungsrichtung der Druckluft. Es ist denkbar, dass die Lackier-Druckluft-Aufbereitungskammer 1 als separates Bauteil in den DruckluftStrom eingebunden oder als Rohrabschnitt im Leitungssystem ausgebildet ist. Wesentlich ist eine Durchströmung des elektromagnetischen Feldes. Eine statische Aussetzung, beispielsweise in Form eines Ausgleichsbehälters oder dergleichen erzeugt nicht den erfindungsgemäßen Effekt.

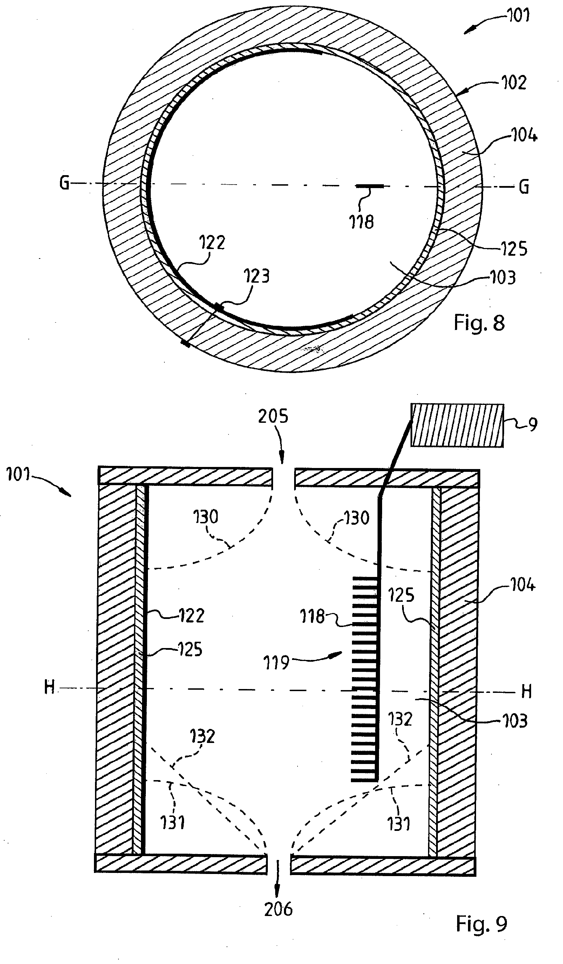

Figur 8 zeigt eine weitere Ausbauform einer erfindungsgemäßen Lackier-Druckluft-Aufbereitungskammer 101 entlang der Schnittlinie H-H. Figur 9 zeigt eine entsprechende Darstellung dieser Kammer entlang der Schnittlinie G-G. Das zylindrische Gehäuse 102 umgibt dabei entsprechend mit seinem Außenmantel 104 einen Hohlraum 103. Im Inneren ist eine Isolationslage 125 angeordnet auf deren Oberfläche zumindest anteilig eine Flächenelektrode 122 als Gegenelektrode 212 vorgesehen ist. Die Flächenelektrode 122 ist über eine elektrisch leitende Verbindung, beispielsweise eine Schraube 123 mit dem Gehäuse 102 verbunden.

Im Inneren des Hohlraums 103 ist als Elektrode 108 eine Kammelektrode 119 mit einer Vielzahl von Elektrodenspitzen 118 angeordnet. Die Elektrodenspitzen 118 haben dabei einen Abstand zwischen 1mm und 200mm und insbesondere zwischen 1mm und 50mm und von vorzugsweise 2mm und sind unmittelbar, ohne einen Elektrodenmantel im Inneren des Hohlraums 103 angeordnet.

Die enge und unisolierte Anordnung der Spitzen verbessert das inhomogene Hochspannungsfeld und glättet die Feldeffekte an den Spitzen aufgrund des geringen Abstands.

Die Lackier-Druckluft-Aufbereitungskammer 101 weist entsprechend einen Lufteinlass 105 und einen Luftauslass 106 auf, durch welche eine Luftdurchströmung ermöglicht wird.
Exemplarisch, jedoch nicht zwingend auf diese Ausführungsform beschränkt ist in den Figuren 8 und 9 sowie 10 und 11 ein

Strömungstrichter 130 auf der Einlassseite und ein Strömungstrichter 131 auf der Auslassseite gestrichelt angedeutet. Die Strömungstrichter 130 und 131 haben eine rotationssymmetrische Form und sind im Inneren des Hohlraums 103 aufgenommen, um das möglichst laminare Strömungsverhalten der Druckluft im Inneren der Lackier-Druckluft-Aufbereitungskammer 101 zu verbessern. In ihrer Einhüllenden sind die Strömungstrichter 130 und 131 nicht linear sondern parabolisch oder hyperbolisch ausgebildet, um einen guten Strömungsverlauf auszubilden. Alternativ kann einseitig oder beidseitig aus strömungstechnischen Gründen oder zur Verbesserung der Fertigungseffizienz (günstiger herstellbar) auch eine lineare Trichterform genutzt werden, wie sie exemplarisch gestrichelt auf der Auslassseite als Strömungstrichter 132 dargestellt ist.

Die Ausführungsform nach Figur 8 und 9 umfasst eine Kammelektrode 119 mit gegenüber den Figuren 1 bis 7 verringertem Abstand der Elektrodenspitzen 118.

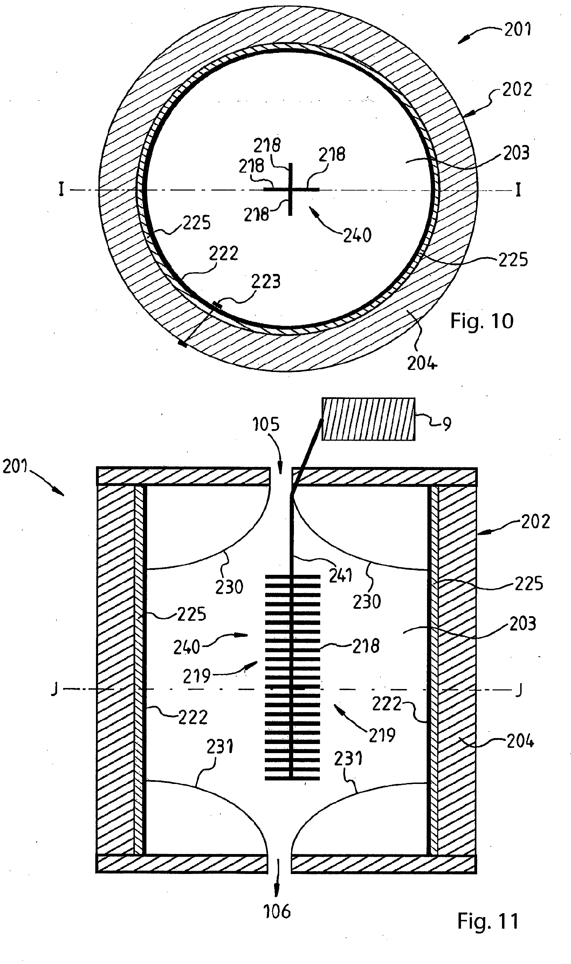

Figur 10 und Figur 11 zeigen eine weitere bevorzugte Ausführungsform der Lackier-Druckluft-Aufbereitungskammer 201. Figur 10 ist dabei ein Schnitt entlang der Linie J-J, Figur 11 ein Schnitt entlang der Linie I-I.

Die Lackier-Druckluft-Aufbereitungskammer 201 umfasst ebenfalls ein Gehäuse 202 mit einem Hohlraum 203. Der Hohlraum wird in dieser Ausführung rundum mit einer Isolationslage 225 umgeben, auf welcher eine Flächenelektrode 222 als Gegenelektrode 212 umlaufend ausgebildet ist. Die Flächenelektrode 222 ist über eine Kontaktierung, beispielsweise eine Schraube 223 mit dem Außenmantel 204 elektrisch leitend verbunden und dadurch geerdet. Alternativ ist es aber auch vorgesehen, die Gegenelektrode als nicht geerdete Gegenelektrode auszuführen, welche isoliert in dem Hohlraum aufgenommen ist. Hierbei ist es vorgesehen, dass die Gegenelektrode aus Blei oder aus Kupfer ausgebildet ist. Strömungstrichter 230 und 231 sind im Innenraum vorgesehen. Auch die lineare Ausführungsform entsprechend der Darstellung 132 ist denkbar (siehe Figur 9).

Die Lackier-Druckluft-Aufbereitungskammer 201 umfasst eine vierfach-Kammelektrode 240, welche umgebend um eine Leitung 241 sternförmig symmetrisch im 90° Winkelabstand als Elektrode 208 Elektrodenkämme 219 aufweist. Die Elektrodenspitzen 218 sind entsprechend der Ausführung der Figuren 8 und 9 im Abstand von bevorzugt 2mm ausgebildet. Gemäß anderer Ausführungsvarianten ist es auch vorgesehen, die Kammelektrode als zweifach- oder dreifach-Kammelektrode bzw. mehrfach-Kammelektrode auszuführen.

Die vierfach-Kammelektrode 240 ist bevorzugt nahezu bis genau zentrisch im Inneren des Hohlraums 203 angeordnet und wird von der Druckluft von der Einlassöffnung 205 zur Auslassöffnung 206 hin umströmt. Gemäß nicht dargestellter Ausführungsvarianten ist die Kammelektrode als n-fach-Kammelektrode ausgeführt, wobei n eine natürliche Zahl größer 1 ist.

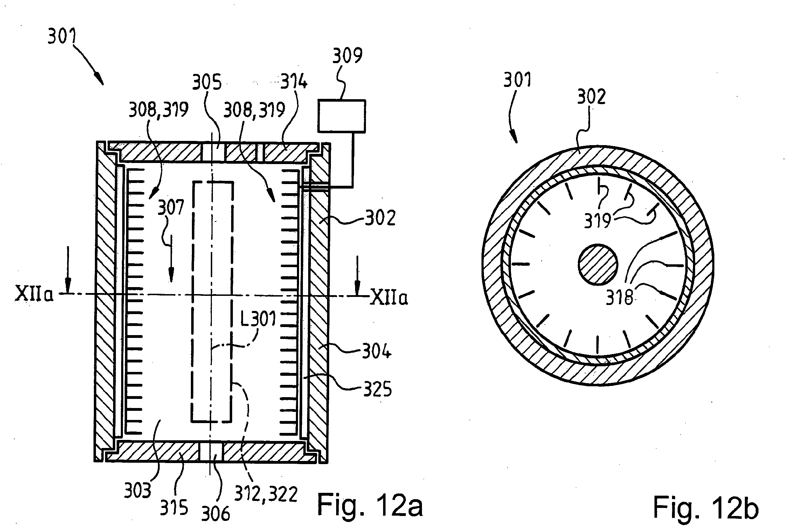

In der Figur 12a ist in geschnittener Seitenansicht eine weitere Lackier-Druckluft-Aufbereitungskammer 301 gezeigt, welche eine Ausführungsvariante zu der in den Figuren 10 und 11 dargestellten Lackier-Druckluft-Aufbereitungskammer bildet. Die Lackier-Druckluft-Aufbereitungskammer 301 umfasst als Elektrode 308 eine Vielzahl von Elektrodenkämmen 319, welche umlaufend entlang einer einen Außenmantel 304 eines Gehäuses 302 auskleidenden Isolationslage 325 in einem Hohlraum 303 angeordnet sind. In dem Gehäuse 302 der Lackier-Druckluft-Aufbereitungskammer 301 verläuft zentrisch bzw. symmetrisch zu einer Längsmittelachse L301 der Lackier-Druckluft-Aufbereitungskammer 301 eine Gegenelektrode 312, welche als stabförmige Flächenelektrode 322 ausgebildet ist, bei welcher die Mantelfläche des Stabs die wirksame Fläche bildet. Gemäß einer nicht dargestellten Ausführungsvariante ist es auch vorgesehen, die Gegenelektrode als Gitterelektrode auszuführen, welche innen insbesondere hohl ausgebildet ist. Wie aus der in der Figur 12b gezeigten Schnittansicht, welche entsprechend der Schnittlinie XIIa-XIIa ausgeführt ist, erkennbar ist, sind wenigstens 16 Elektrodenkämme 319 parallel zueinander und in eine Strömungsrichtung 307 verlaufend gleichmäßig am Innenumfang verteilt positioniert. Gemäß anderer, nicht dargestellter Ausführungsvarianten ist es aber auch vorgesehen, nur zwei oder mehr Elektrodenkämme in eine Strömungsrichtung 307 verlaufend gleichmäßig am Innenumfang verteilt zu positionieren. Die Elektrodenkämme 319 weisen mit ihren Elektrodenspitzen 318 zu der Elektrode 308 jeweils gleiche radial gemessene Abstände auf. Die Gegenelektrode 312 ist durch eine nicht dargestellte, nicht leitende Halteeinrichtung in dem Gehäuse an ihrer gezeigten Position gehalten und somit ohne Erdung in dem Hohlraum 303 aufgenommen. Die Elektrodenkämmen 319 sind allesamt an eine Hochspannungsquelle 309 angeschlossen und sind ohne leitenden Kontakt zu dem Gehäuse 302 gehalten. Das Gehäuse 302 umfasst neben dem Außenmantel 304 einen oberen Abschlussdeckel 314 und einen unteren Abschlussdeckel 315. Diese weisen eine Lufteinlassöffnung 305 und eine Lufteinlassöffnung 306 auf. Gemäß einer nicht dargestellten Ausführungsvariante ist es auch vorgesehen, die Gegenelektrode zu erden.

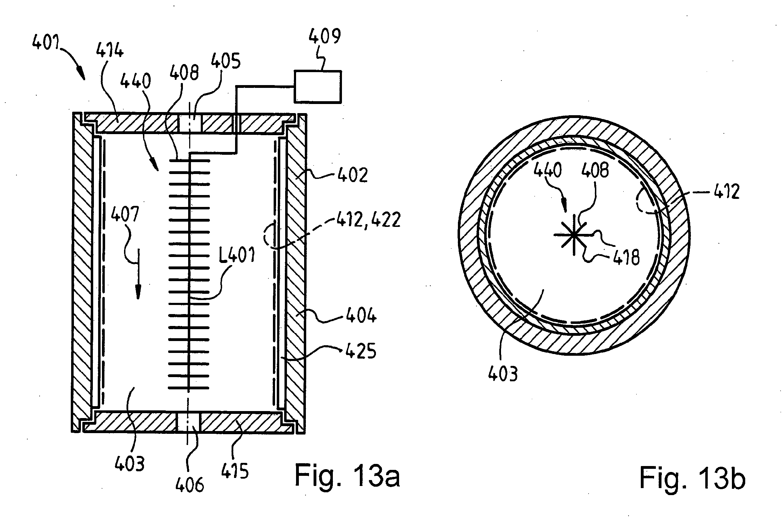

In der Figur 13a ist in geschnittener Seitenansicht eine weitere Lackier-Druckluft-Aufbereitungskammer 401 gezeigt, welche eine weitere Ausführungsvariante zu der in den Figuren 10 und 11 dargestellten Lackier-Druckluft-Aufbereitungskammer bildet. Die Lackier-Druckluft-Aufbereitungskammer 401 umfasst als Elektrode 408 eine 8-fach Kammelektrode 440, welche ebenfalls zentrisch in Bezug auf einen Außenmantel 404 eines Gehäuses 402 angeordnet ist. Gemäß anderer, nicht dargestellter Ausführungsvarianten ist es aber auch vorgesehen, Kammelektroden mit anderer Spitzenzahl zu verwenden. Der Außenmantel 404 ist mit einer Isolationslage 425 ausgekleidet. In dem Gehäuse 402 der Lackier-Druckluft-Aufbereitungskammer 401 ist zylindermantelförmig umlaufend und symmetrisch zu einer Längsmittelachse L401 der Lackier-Druckluft-Aufbereitungskammer 401 eine Gegenelektrode 412 als Flächenelektrode 422 angeordnet. Wie aus der in der Figur 13b gezeigten Schnittansicht, welche entsprechend der Schnittlinie XIIIa-XIIIa ausgeführt ist, erkennbar ist, sind die Elektrode 408 und die Gegenelektrode 412 zentrisch und symmetrisch in dem Gehäuse 402 angeordnet. Die Kammelektrode 440 weist mit ihren Elektrodenspitzen 418 zu der umlaufenden Elektrode 408 jeweils gleiche, radial gemessene Abstände auf. Die Elektrode 408 ist durch eine nicht dargestellte, nicht leitende Halteeinrichtung in dem Gehäuse 402 an ihrer gezeigten Position gehalten und somit ohne leitende Verbindung in dem Hohlraum 403 aufgenommen. Die Kammelektrode 440 ist an eine Hochspannungsquelle 409 angeschlossen und ebenfalls ohne leitenden Kontakt zu dem Gehäuse 402 gehalten. Das Gehäuse 402 umfasst neben dem Außenmantel 404 einen oberen Abschlussdeckel 414 und einen unteren Abschlussdeckel 415. Diese weisen eine Lufteinlassöffnung 405 und eine Lufteinlassöffnung 406 auf.

Gemäß nicht dargestellter Ausführungsvarianten ist es bei den in den Figuren 1 bis 13b gezeigten Ausführungsbeispielen auch vorgesehen, dass der Außenmantel geerdet ist. Somit ist indirekt auch die Gegenelektrode geerdet, wenn diese über eine leitfähige Verbindung mit dem Außenmantel verbunden ist. Derartige Ausführungsvarianten sind dadurch gekennzeichnet, dass der Außenmantel geerdet ist und dass die Gegenelektrode über eine leitfähige Verbindung mit dem Außenmantel verbunden ist. Weitere Ausführungsvarianten weisen zwar einen geerdeten Außenmantel, aber nicht geerdete Gegenelektroden auf.

Es ist auch vorgesehen, dass sich die Elektrode über wenigstens 60% und insbesondere mehr als 90% einer Strecke zwischen dem oberen Abschlussdeckel und dem unteren Abschlussdeckel erstreckt und dass sich die Gegenelektrode über die gesamte Strecke zwischen dem oberen Abschlussdeckel und dem unteren Abschlussdeckel erstreckt. Hierdurch ist die Lackier-Druckluft-Aufbereitungskammer so ausgestaltet, dass Druckluft, welche den Hohlraum der Lackier-Druckluft-Aufbereitungskammer durchströmt, auf einem Großteil ihres Weges von der Lufteintrittsöffnung bis zur Luftaustrittsöffnung das elektromagnetische Feld durchströmt. Weiterhin ist es hierdurch sichergestellt, dass sich Elektrode und Gegenelektrode über die gesamte Längserstreckung der Elektrode quer zu der Strömungsrichtung gegenüber liegen und so das erzeugte elektromagnetische Feld optimal von der Druckluft durchströmt wird.

Bei dem Verfahren zum Betrieb einer Lackier-Druckluft-Aufbereitungskammer nach einem der Ansprüche 1 bis 14 ist es vorgesehen, dass zwischen der Elektrode und der Gegenelektrode ein Hochspannungsfeld, insbesondere ein Hochspannungs-Wechselfeld angelegt ist, wobei eine Hochspannung zwischen 800V und 100kV, insbesondere zwischen 2kV und 20kV, vorzugsweise zwischen 4kV und 16kV und besonders bevorzugt zwischen 5kV und 8kV angelegt ist, wobei in dem Hohlraum der Lackier-Druckluft-Aufbereitungskammer bei angelegter Hochspannung ein inhomogenes elektromagnetisches Feld ausgebildet wird und das inhomogenes elektromagnetisches Feld von Druckluft durchströmt wird.
Die Lackier-Druckluft-Aufbereitungskammer wird derart betrieben bzw. ist hinsichtlich ihrer Elektrode und ihrer Gegenelektrode derart ausgelegt, dass in ihrem Hohlraum ein positiver Ladungsüberschuss also ein Überschuss an positiven Ladungen vorhanden ist. Gemäß einer Ausführungsvariante wird die Lackier-Druckluft-Aufbereitungskammer derart betrieben bzw. ist hinsichtlich ihrer Elektrode und ihrer Gegenelektrode derart ausgelegt, dass in ihrem Hohlraum ein negativer Ladungsüberschuss also ein Überschuss an negativen Ladungen vorhanden ist. Gemäß einer weiteren Ausführungsvariante wird die Lackier-Druckluft-Aufbereitungskammer derart betrieben bzw. ist hinsichtlich ihrer Elektrode und ihrer Gegenelektrode derart ausgelegt, dass in ihrem Hohlraum ein neutraler Ladungszustand eingestellt bzw. erhalten wird.

Als Flächenelektrode ist im weitesten Sinne eine metallische Fläche zu verstehen. Hierbei ist diese Fläche gemäß alternativer Ausführungsformen insbesondere auch durch eine Mantelfläche eines Stabs oder durch Mantelflächen mehrerer Stäbe ausgebildet.

Als Kammelektrode im Sinne der Erfindung ist eine Anzahl von Entladungsspitzen an einem Träger zu verstehen, wobei die Entladungsspitzen in der Form eines Kamms abstehen und mit ihren Spitzenenden im freien Raum liegen. Die Kontaktierung erfolgt über den Träger als elektrischer Leiter, der üblicherweise mit einer Spannungsquelle verbunden wird.

Als Isolationslage im Sinne der Erfindung ist sowohl eine Kunststofflage, fest oder lösbar mit dem Gehäuse verbunden, eine Oberflächenbeschichtung, insbesondere ein Isolationslack oder eine chemisch erzeugte Schicht wie insbesondere eine Eloxal-Schicht denkbar.

Als inhomogenes elektromagnetisches Feld ist ein Feld mit im Wesentlichen gekrümmten Feldlinien zu verstehen.

### Bezugszeichenliste:

- 1: Lackier-Druckluft-Aufbereitungskammer
- 2: Gehäuse
- 3: Hohlraum
- 4: Außenmantel
- 5: Lufteintrittsöffnung
- 6: Luftaustrittsöffnung
- 7: Strömungsrichtung
- 8: Elektrode
- 9: Hochspannungsquelle
- 10: Isolationslage
- 11: Innenfläche des Außenmantels
- 12: Gegenelektrode
- 13: aktive Zone
- 14: Abschlussdeckel oben
- 15: Abschlussdeckel unten
- 16: Isolationslage oben
- 17: Isolationslage unten
- 18: Elektrodenspitze
- 19: Kammelektrode
- 20: Mittelachse des Hohlraums
- 21: Elektrodenmantel
- 22: Flächenelektrode
- 23: Verbindung, leitfähig
- 24: Hohlzylinder
- 25: Isolationslage als Schicht
- 101: Lackier-Druckluft-Aufbereitungskammer
- 102: Gehäuse
- 103: Hohlraum
- 104: Außenmantel
- 105: Lufteintrittsöffnung
- 106: Luftaustrittsöffnung
- 108: Elektrode
- 112: Gegenelektrode
- 118: Elektrodenspitze
- 119: Kammelektrode
- 122: Flächenelektrode
- 123: Verbindung, leitfähig
- 125: Isolationslage
- 130: Strömungstrichter nichtlinear
- 131: Strömungstrichter nichtlinear
- 132: Strömungstrichter linear
- 201: Lackier-Druckluft-Aufbereitungskammer
- 202: Gehäuse
- 203: Hohlraum
- 204: Außenmantel
- 205: Lufteintrittsöffnung
- 206: Luftaustrittsöffnung
- 208: Elektrode
- 212: Gegenelektrode
- 218: Elektrodenspitze
- 219: Kammelektrode
- 222: Flächenelektrode
- 223: Verbindung, leitfähig
- 225: Isolationslage
- 230: Strömungstrichter nichtlinear
- 231: Strömungstrichter nichtlinear
- 240: vierfach Kammelektrode
- 241: Leitung
- 301: Lackier-Druckluft-Aufbereitungskammer
- 302: Gehäuse
- 303: Hohlraum
- 304: Außenmantel
- 305: Lufteintrittsöffnung
- 306: Luftaustrittsöffnung
- 307: Strömungsrichtung
- 308: Elektrode
- 312: Gegenelektrode
- 314: Abschlussdeckel oben
- 315: Abschlussdeckel unten
- 318: Elektrodenspitze
- 319: Kammelektrode
- 322: Flächenelektrode
- 325: Isolationslage
- L301: Längsmittelachse
- 401: Lackier-Druckluft-Aufbereitungskammer
- 402: Gehäuse
- 403: Hohlraum
- 404: Außenmantel
- 405: Lufteintrittsöffnung
- 406: Luftaustrittsöffnung
- 407: Strömungsrichtung
- 408: Elektrode
- 412: Gegenelektrode
- 414: Abschlussdeckel oben
- 415: Abschlussdeckel unten
- 418: Elektrodenspitze
- 422: Flächenelektrode
- 425: Isolationslage
- 440: mehrfach-Kammelektrode
- L401: Längsmittelachse

## Patentansprüche

1. Lackier-Druckluft-Aufbereitungskammer (1; 101; 201; 301; 401) zur Verbesserung der Strömungseigenschaften von Druckluft oder Druckgasgemischen im Lackierprozess umfassend,
- ein Gehäuse (2; 102; 202; 302; 402) zur Bildung eines Hohlraums (3; 103; 203; 303; 403), wobei das Gehäuse (2; 102; 202; 302; 402) einen den Hohlraum (3; 103; 203; 303; 403) begrenzenden Außenmantel (4; 104; 204; 304; 404) umfasst;
- mindestens eine Lufteintrittsöffnung (5; 305; 405) sowie mindestens eine Luftaustrittsöffnung (6; 306; 406), wobei die Lufteintrittsöffnung (5; 305; 405) und die Luftaustrittsöffnung (6; 306; 406) derart angeordnet sind, dass der Hohlraum (3; 103; 203; 303; 403) von der Druckluft oder dem Druckgasgemisch durchströmbar, vorzugsweise in einer Längsrichtung durchströmbar ist;
- mindestens eine innerhalb des Hohlraums (3; 103; 203; 303; 403) angeordnete Elektrode (8, 19; 108, 119; 208, 219; 308; 319;);
- mindestens eine Hochspannungsquelle (9) zur Versorgung der Elektrode (8, 19; 108, 119; 208, 219; 308; 319; 408, 440) mit Hochspannung,
**dadurch gekennzeichnet, dass**
- mindestens eine Isolationslage (10; 25; 125; 225; 325; 425) innerhalb des Hohlraums (3; 103; 203; 303; 403) an einer Innenfläche (11) des Außenmantels (4; 104; 204; 304; 404) angeordnet ist und
- im Inneren des Hohlraums (3; 103; 203; 303; 403), zwischen der Elektrode (8, 19; 108, 119; 208, 219; 308; 319; 408, 440) und einer Gegenelektrode (12, 22; 112, 122; 212, 222; 312, 322; 412, 422) ein elektromagnetisches Hochspannungs-Wechselfeld , vorzugsweise ein inhomogenes elektromagnetisches Hochspannungs-Wechselfeld oder ein teilweise inhomogenes elektromagnetisches Hochspannungs-Wechselfeld, mit einer aktiven Zone (13) zur Durchströmung mit aufzubereitender Druckluft erzeugbar ist.

2. Lackier-Druckluft-Aufbereitungskammer nach Anspruch 1, **dadurch gekennzeichnet, dass** die Isolationslage (10; 25; 125; 225; 325; 425) mindestens 75% der Innenfläche, vorzugsweise die gesamte Innenfläche des Außenmantels (4; 104; 204; 304; 404) überdeckt.

3. Lackier-Druckluft-Aufbereitungskammer nach Anspruch 1 oder 2, **dadurch gekennzeichnet, dass** das Gehäuse (2; 102; 202; 302; 402) zwei Abschlussdeckel (14, 15; 314, 315; 414; 415) umfasst wobei mindestens einer, vorzugsweise beide Abschlussdeckel (14, 15; 314, 315; 414; 415) auf einer dem Hohlraum (3; 103; 203; 303; 403) zugewandten Seite eine Isolationslage (16, 17) aufweisen oder eine Isolationslage (10) zwischen Hohlraum (3; 103; 203; 303; 403) und Abschlussdeckel (14, 15) angeordnet ist wobei vorzugsweise die Isolationslage (10) und/oder ein Isolationskern mit einem trichterförmigen Querschnitt im Inneren des Hohlraums (3; 103; 203; 303; 403) ausgebildet ist, um eine laminare Luftströmung zu begünstigen.

4. Lackier-Druckluft-Aufbereitungskammer nach einem der vorangegangenen Ansprüche, **dadurch gekennzeichnet, dass** die Elektrode (8; 108; 208; 308; 408) als Spitzenelektrode, vorzugsweise als Kammelektrode (19; 119; 219, 240; 319; 440) mit mehreren Spitzen ausgebildet ist.

5. Lackier-Druckluftkammer nach einem der vorangegangenen Ansprüche, **dadurch gekennzeichnet, dass** das elektromagnetische Feld als ein inhomogenes elektromagnetisches Feld, ausgehend von einer Mehrzahl von Elektrodenspitzen (18; 318; 418), vorzugsweise mit einem Spitzenabstand von 1mm bis 200mm, insbesondere 1mm bis 100mm, insbesondere 1mm bis 50mm und vorzugsweise 2mm ausgebildet ist.

6. Lackier-Druckluft-Aufbereitungskammer nach einem der vorangegangenen Ansprüche, **dadurch gekennzeichnet, dass** die Elektrode (8; 108; 208) asymmetrisch zu einer Mittelachse (20) des Hohlraums (3; 103; 203) positioniert ist, insbesondere im Verhältnis 1/3 zu 2/3 zwischen dem Außenmantel (4; 104; 204) und der Mittelachse (20) angeordnet ist oder dass die Elektrode (8; 108; 208; 308) zu der Gegenelektrode (12; 112; 212; 312) in Abständen von 0,5cm bis 20cm und insbesondere 1cm bis 15cm und vorzugsweise 2cm bis 12cm zueinander angeordnet sind.

7. Lackier-Druckluft-Aufbereitungskammer nach einem der vorangegangenen Ansprüche, **dadurch gekennzeichnet, dass** die Elektrode (219; 419) sternförmig im Bereich des Zentrums des Hohlraums (203; 403), insbesondere symmetrisch zu einer Mittelachse des Hohlraums (203; 403) positioniert ist, insbesondere als Sternform mit 2, 3 oder 4 oder mehr Strahlen ausgebildet ist.

8. Lackier-Druckluft-Aufbereitungskammer nach einem der vorangegangenen Ansprüche, **dadurch gekennzeichnet, dass** die Elektrode (8, 19) einen Elektrodenmantel (21) umfasst, wobei der Elektrodenmantel (21) gegenüber dem Außenmantel (4) oder einer Erdung entweder keine elektrisch leitfähige Verbindung oder eine elektrisch leitfähige Verbindung aufweist.

9. Lackier-Druckluft-Aufbereitungskammer nach einem der vorangegangenen Ansprüche 1 bis 7, **dadurch gekennzeichnet, dass** die Elektrode (108, 119; 208, 209; 308, 319; 408) frei, ohne einen Elektrodenmantel oder eine Isolationslage ausgebildet ist.

10. Lackier-Druckluft-Aufbereitungskammer nach einem der Ansprüche 1 bis 9, **dadurch gekennzeichnet, dass** die Gegenelektrode (12; 412) durch die Innenfläche (11) des Außenmantels (4; 404) unter Zwischenschaltung der Isolationslage (10; 425) als Dielektrikum gebildet ist.

11. Lackier-Druckluft-Aufbereitungskammer nach einem der Ansprüche 1 bis 10, **dadurch gekennzeichnet, dass** die Gegenelektrode (12) durch eine Flächenelektrode (22) unter Zwischenschaltung der Isolationslage (10) als Dielektrikum zwischen Flächenelektrode (22) und Innenfläche (11) des Außenmantels (4) gebildet ist.

12. Lackier-Druckluft-Aufbereitungskammer nach Anspruch 11, **dadurch gekennzeichnet, dass** die Flächenelektrode (22) mit dem Außenmantel (4) verbunden, vorzugsweise elektrische leitfähig verbunden ausgebildet ist und/oder dass die Flächenelektrode (22) als metallisches Gitter oder als metallische Vollfläche ausgebildet ist.

13. Lackier-Druckluft-Aufbereitungskammer nach einem der Ansprüche 1 bis 12, **dadurch gekennzeichnet, dass** Isolationslage (10) als in den Hohlraum (3) eingeschobener Hohlkörper, insbesondere als Rohrabschnitt oder Hohlzylinder (24) ausgebildet ist oder dass die Isolationslage (10) als auf der Innenfläche (11) des Außenmantels (4) aufgebrachte Schicht, insbesondere als chemisch aufgebrachte Schicht oder Lackschicht oder Kunststoff-Schmelzschicht oder dergleichen ausgebildet ist.

14. Lackier-Druckluft-Aufbereitungskammer nach einem der vorangegangenen Ansprüche, **dadurch gekennzeichnet, dass** die aktive Zone (13) entweder mindestens 1/3 eins Hohlraumdurchmessers, vorzugsweise zwischen 1/3 bis 2/3 des Hohlraumdurchmessers, insbesondere 1/2 des Hohlraumdurchmessers umfasst oder den ganzen Hohlraumdurchmesser umfasst.

15. Verfahren zum Betrieb einer Lackier-Druckluft-Aufbereitungskammer (1; 101; 201; 301; 401) nach einem der vorangegangenen Ansprüche, **dadurch gekennzeichnet, dass** zwischen Elektrode (8, 19; 108, 119; 208, 219; 308; 319; 408) und Gegenelektrode (12, 22; 112, 122; 212, 222; 312, 322; 412, 422) ein Hochspannungs-Wechselfeld angelegt ist, wobei eine Hochspannung zwischen 800V und 100kV, insbesondere zwischen 2kV und 20kV, vorzugsweise zwischen 4kV und 16kV und besonders bevorzugt zwischen 5kV bis 8kV angelegt ist.

## Claims

1. Painting compressed-air treatment chamber (1; 101; 201; 301; 401) for improving the flow properties of compressed air or compressed gas mixtures in the painting process, comprising
- a housing (2; 102; 202; 302; 402) for forming a cavity (3; 103; 203; 303; 403), wherein the housing (2; 102; 202; 302; 402) comprises an outer sheath (4; 104; 204; 304; 404) bounding the cavity (3; 103; 203; 303; 403);
- at least one air inlet opening (5; 305; 405) and at least one air outlet opening (6; 306; 406), wherein the air inlet opening (5; 305; 405) and the air outlet opening (6; 306; 406) are arranged such that the compressed air or the compressed gas mixture is able to flow through the cavity (3; 103; 203; 303; 403), preferably able to flow through it in a longitudinal direction;
- at least one electrode (8, 19; 108, 119; 208, 219; 308; 319) arranged inside the cavity (3; 103; 203; 303; 403);
- at least one high-voltage source (9) for supplying a high voltage to the electrode (8, 19; 108, 119; 208, 219; 308; 319; 408, 440)
**characterized in that**
- at least one insulation layer (10; 25; 125; 225; 325; 425) is arranged inside the cavity (3; 103; 203; 303; 403) on an inner surface (11) of the outer sheath (4; 104; 204; 304; 404) and
- an electromagnetic high-voltage alternating field, preferably an inhomogeneous electromagnetic high-voltage alternating field or a partly inhomogeneous electromagnetic high-voltage alternating field, having an active zone (13) to be flowed through by compressed air to be treated, is able to be generated inside the cavity (3; 103; 203; 303; 403), between the electrode (8, 19; 108, 119; 208, 219; 308; 319; 408, 440) and a counterelectrode (12, 22; 112, 122; 212, 222; 312, 322; 412, 422).

2. Painting compressed-air treatment chamber according to Claim 1, **characterized in that** the insulation layer (10; 25; 125; 225; 325; 425) covers at least 75% of the inner surface, preferably the entire inner surface of the outer sheath (4; 104; 204; 304; 404).

3. Painting compressed-air treatment chamber according to Claim 1 or 2, **characterized in that** the housing (2; 102; 202; 302; 402) comprises two closure covers (14, 15; 314, 315; 414; 415), wherein at least one, preferably both closure covers (14, 15; 314, 315; 414; 415) have an insulation layer (16, 17) on a side facing the cavity (3; 103; 203; 303; 403) or an insulation layer (10) is arranged between the cavity (3; 103; 203; 303; 403) and the closure cover (14, 15), wherein the insulation layer (10) and/or an insulation core is preferably formed with a funnel-shaped cross section inside the cavity (3; 103; 203; 303; 403) in order to promote a laminar airflow.

4. Painting compressed-air treatment chamber according to one of the preceding claims, **characterized in that** the electrode (8; 108; 208; 308; 408) is formed as a point electrode, preferably as a comb electrode (19; 119; 219, 240; 319; 440) with a plurality of points.

5. Painting compressed-air chamber according to one of the preceding claims, **characterized in that** the electromagnetic field is formed as an inhomogeneous electromagnetic field, emanating from a multiplicity of electrode points (18; 318; 418), preferably having a point spacing of 1 mm to 200 mm, in particular 1 mm to 100 mm, in particular 1 mm to 50 mm and preferably 2 mm.

6. Painting compressed-air treatment chamber according to one of the preceding claims, **characterized in that** the electrode (8; 108; 208) is positioned asymmetrically about a centre axis (20) of the cavity (3; 103; 203), in particular is arranged at a ratio of 1/3 to 2/3 between the outer sheath (4; 104; 204) and the centre axis (20), or **in that** the electrode (8; 108; 208; 308) and the counterelectrode (12; 112; 212; 312) are arranged at spacings of 0.5 cm to 20 cm and in particular 1 cm to 15 cm and preferably 2 cm to 12 cm with respect to one another.

7. Painting compressed-air treatment chamber according to one of the preceding claims, **characterized in that** the electrode (219; 419) is positioned in a star shape in the region of the centre of the cavity (203; 403), in particular symmetrically about a centre axis of the cavity (203; 403), in particular is formed in a star shape with 2, 3 or 4 or more beams.

8. Painting compressed-air treatment chamber according to one of the preceding claims, **characterized in that** the electrode (8, 19) comprises an electrode sheath (21), wherein the electrode sheath (21) either does not have any electrically conductive connection or has an electrically conductive connection with respect to the outer sheath (4) or ground.

9. Painting compressed-air treatment chamber according to one of preceding Claims 1 to 7, **characterized in that** the electrode (108, 119; 208, 209; 308, 319; 408) is formed freely, without an electrode sheath or an insulation layer.

10. Painting compressed-air treatment chamber according to one of Claims 1 to 9, **characterized in that** that the counterelectrode (12; 412) is formed by the inner surface (11) of the outer sheath (4; 404) with the interposition of the insulation layer (10; 425) as dielectric.

11. Painting compressed-air treatment chamber according to one of Claims 1 to 10, **characterized in that** the counterelectrode (12) is formed by a surface electrode (22) with the interposition of the insulation layer (10) as dielectric between the surface electrode (22) and the inner surface (11) of the outer sheath (4).

12. Painting compressed-air treatment chamber according to Claim 11, **characterized in that** the surface electrode (22) is connected to the outer sheath (4), is preferably designed to be electrically conductively connected and/or in that the surface electrode (22) is formed as a metal grating or as a continuous metal surface.

13. Painting compressed-air treatment chamber according to one of Claims 1 to 12, **characterized in that** the insulation layer (10) is formed as a hollow body inserted into the cavity (3), in particular is formed as a tubular section or hollow cylinder (24) or **in that** the insulation layer (10) is formed as a layer applied to the inner surface (11) of the outer sheath (4), in particular as a chemically applied layer or paint layer or plastic melting layer or the like.

14. Painting compressed-air treatment chamber according to one of the preceding claims, **characterized in that** the active zone (13) covers either at least 1/3 of one cavity diameter, preferably between 1/3 and 2/3 of the cavity diameter, in particular covers 1/2 of the cavity diameter or covers the whole cavity diameter.

15. Method for operating a painting compressed-air treatment chamber (1; 101; 201; 301; 401) according to one of the preceding claims, **characterized in that** a high-voltage alternating field is applied between the electrode (8, 19; 108, 119; 208, 219; 308; 319; 408) and the counterelectrode (12, 22; 112, 122; 212, 222; 312, 322; 412, 422), wherein a high voltage of between 800 V and 100 kV, in particular between 2 kV and 20 kV, preferably between 4 kV and 16 kV and particularly preferably between 5 kV and 8 kV is applied.

## Revendications

1. Chambre de conditionnement d'air comprimé de vernissage (1 ; 101 ; 201 ; 301 ; 401) destinée à améliorer les propriétés d'écoulement de l'air comprimé ou de mélanges gazeux dans un processus de vernissage, comprenant
- un boîtier (2 ; 102 ; 202 ; 302 ; 402) destiné à former un espace vide (3 ; 103 ; 203 ; 303 ; 403), le boîtier (2 ; 102 ; 202 ; 302 ; 402) comportant une enveloppe extérieure (4 ; 104 ; 204 ; 304 ; 404) de délimitation de l'espace vide (3 ; 103 ; 203 ; 303 ; 403) ;
- au moins une ouverture d'entrée d'air (5 ; 305 ; 405) ainsi qu'au moins une ouverture de sortie d'air (6 ; 306 ; 406), l'ouverture d'entrée d'air (5 ; 305 ; 405) et l'ouverture de sortie d'air (6 ; 306 ; 406) étant disposées de telle sorte que l'espace vide (3 ; 103 ; 203 ; 303 ; 403) peut être traversé par le flux d'air comprimé ou du mélange gazeux, de préférence traversé dans une direction longitudinale ;
- au moins une électrode (8, 19 ; 108, 119 ; 208, 219 ; 308 ; 319) disposée à l'intérieur de l'espace vide (3 ; 103 ; 203 ; 303 ; 403) ;
- au moins une source de haute tension (9) destinée à alimenter l'électrode (8, 19 ; 108, 119 ; 208, 219 ; 308 ; 319 ; 408, 440) en haute tension,
**caractérisée en ce que**
- au moins une couche isolante (10 ; 25 ; 125 ; 225 ; 325 ; 425) est disposée à l'intérieur de l'espace vide (3 ; 103 ; 203 ; 303 ; 403) sur une surface intérieure (11) de l'enveloppe extérieure (4 ; 104 ; 204 ; 304 ; 404) et
- un champ alternatif à haute tension électromagnétique, de préférence un champ alternatif à haute tension électromagnétique inhomogène ou un champ alternatif à haute tension électromagnétique partiellement inhomogène, comprenant une zone active (13) destinée à être traversée par le flux d'air comprimé à conditionner, peut être généré à l'intérieur de l'espace vide (3 ; 103 ; 203 ; 303 ; 403), entre l'électrode (8, 19 ; 108, 119 ; 208, 219 ; 308 ; 319 ; 408, 440) et une contre-électrode (12, 22 ; 112, 122 ; 212, 222 ; 312, 322 ; 412, 422).

2. Chambre de conditionnement d'air comprimé de vernissage selon la revendication 1, **caractérisée en ce que** la couche isolante (10 ; 25 ; 125 ; 225 ; 325 ; 425) recouvre au moins 75 % de la surface intérieure, de préférence la totalité de la surface intérieure de l'enveloppe extérieure (4 ; 104 ; 204 ; 304 ; 404).

3. Chambre de conditionnement d'air comprimé de vernissage selon la revendication 1 ou 2, **caractérisée en ce que** le boîtier (2 ; 102 ; 202 ; 302 ; 402) comporte deux couvercles de fermeture (14, 15 ; 314, 315 ; 414, 415), au moins un, de préférence les deux couvercles de fermeture (14, 15 ; 314, 315 ; 414, 415), possédant sur un côté qui fait face à l'espace vide (3 ; 103 ; 203 ; 303 ; 403) une couche isolante (16, 17) ou alors une couche isolante (10) étant disposée entre l'espace vide (3 ; 103 ; 203 ; 303 ; 403) et les couvercles de fermeture (14, 15), la couche isolante (10) et/ou un noyau isolant étant formé(e) avec une section transversale en forme d'entonnoir à l'intérieur de l'espace vide (3 ; 103 ; 203 ; 303 ; 403) afin de favoriser un écoulement d'air laminaire.

4. Chambre de conditionnement d'air comprimé de vernissage selon l'une des revendications précédentes, **caractérisée en ce que** l'électrode (8 ; 108 ; 208 ; 308 ; 408) est réalisée sous la forme d'une électrode à pointe, de préférence sous la forme d'une électrode en peigne (19 ; 119 ; 219 ; 319 ; 440) ayant plusieurs pointes.

5. Chambre de conditionnement d'air comprimé de vernissage selon l'une des revendications précédentes, **caractérisée en ce que** le champ électromagnétique est réalisé sous la forme d'un champ électromagnétique inhomogène émanant d'une pluralité de pointes d'électrode (18 ; 318 ; 418), de préférence avec un écart entre pointes de 1 mm à 200 mm, notamment de 1 mm à 100 mm, notamment de 1 mm à 50 mm et de préférence de 2 mm.

6. Chambre de conditionnement d'air comprimé de vernissage selon l'une des revendications précédentes, **caractérisée en ce que** l'électrode (8 ; 108 ; 208) est positionnée de manière asymétrique par rapport à un axe central (20) de l'espace vide (3 ; 103 ; 203), notamment dans un rapport de 1/3 à 2/3 entre l'enveloppe extérieure (4 ; 104 ; 204) et l'axe central (20), ou **en ce que** l'électrode (8 ; 108 ; 208 ; 308) est disposée par rapport à la contre-électrode (12 ; 112 ; 212 ; 312) à des écarts de 0,5 cm à 20 cm et notamment de 1 cm à 15 cm et de préférence de 2 cm à 12 cm l'une par rapport à l'autre.

7. Chambre de conditionnement d'air comprimé de vernissage selon l'une des revendications précédentes, **caractérisée en ce que** l'électrode (219 ; 419) est positionnée en forme d'étoile dans la zone du centre de l'espace vide (203 ; 403), notamment de manière symétrique par rapport à un axe central de l'espace vide (203 ; 403), notamment sous la forme d'une étoile avec 2, 3 ou 4 branches ou plus.

8. Chambre de conditionnement d'air comprimé de vernissage selon l'une des revendications précédentes, **caractérisée en ce que** l'électrode (8, 19) comporte une enveloppe d'électrode (21), l'enveloppe d'électrode (21) possédant, par rapport à l'enveloppe extérieure (4) ou à une mise à la terre, soit aucune liaison électriquement conductrice, soit une liaison électriquement conductrice.

9. Chambre de conditionnement d'air comprimé de vernissage selon l'une des revendications 1 à 7, **caractérisée en ce que** l'électrode (108, 119 ; 208, 209 ; 308, 319 ; 408) est formée de manière dégagée, sans une enveloppe d'électrode ou une couche isolante.

10. Chambre de conditionnement d'air comprimé de vernissage selon l'une des revendications 1 à 9, **caractérisée en ce que** la contre-électrode (12 ; 412) est formée par la surface intérieure (11) de l'enveloppe extérieure (4 ; 404) en interposant la couche isolante (10 ; 425) en tant que diélectrique.

11. Chambre de conditionnement d'air comprimé de vernissage selon l'une des revendications 1 à 10, **caractérisée en ce que** la contre-électrode (12) est formée par une électrode plane (22) en interposant la couche isolante (10) en tant que diélectrique entre l'électrode plane (22) et la surface intérieure (11) de l'enveloppe extérieure (4).

12. Chambre de conditionnement d'air comprimé de vernissage selon la revendication 11, **caractérisée en ce que** l'électrode plane (22) est réalisée de manière reliée, de préférence reliée de manière électriquement conductrice à l'enveloppe extérieure (4) et/ou **en ce que** l'électrode plane (22) est réalisée sous la forme d'une grille métallique ou sous la forme d'une surface complète métallique.

13. Chambre de conditionnement d'air comprimé de vernissage selon l'une des revendications 1 à 12, **caractérisée en ce que** la couche isolante (10) est réalisée sous la forme d'un corps creux inséré dans l'espace vide (3), notamment sous la forme d'une portion tubulaire ou d'un cylindre creux (24), ou **en ce que** la couche isolante (10) est réalisée sous la forme d'une couche appliquée sur la surface intérieure (11) de l'enveloppe extérieure (4), notamment sous la forme d'une couche appliquée par procédé chimique ou d'une couche de vernis ou d'une couche de matière plastique fondue ou similaire.

14. Chambre de conditionnement d'air comprimé de vernissage selon l'une des revendications précédentes, **caractérisée en ce que** la zone active (13) comprend soit au moins 1/3 d'un diamètre d'espace vide, de préférence entre 1/3 et 2/3 du diamètre d'espace vide, notamment 1/2 du diamètre d'espace vide soit la totalité du diamètre d'espace vide.

15. Procédé pour faire fonctionner une chambre de conditionnement d'air comprimé de vernissage (1 ; 101 ; 201 ; 301 ; 401) selon l'une des revendications précédentes, **caractérisé en ce qu'**un champ alternatif à haute tension est appliqué entre l'électrode (8, 19 ; 108, 119 ; 208, 219 ; 308 ; 319 ; 408) et la contre-électrode (12, 22 ; 112, 122 ; 212, 222 ; 312, 322 ; 412, 422), une haute tension entre 800 V et 100 kV, notamment entre 2 kV et 20 kV, de préférence entre 4kV et 16kV et de manière particulièrement préférée entre 5 kV et 8 kV étant appliquée.
